# EUROPÄISCHE PATENTANMELDUNG

(11) **EP 1 783 242 A1**
(43) Veröffentlichungstag der Anmeldung: **09.05.2007**
(21) Anmeldenummer: 05024348.4
(22) Anmeldetag: 08.11.2005
(51) Int. Cl.: C23C 8/36, C23C 14/54, C23C 14/02

(54) **Verfahren zum Vorheizen eines Bauteils und Beschichtungsverfahren**

(71) Anmelder: SIEMENS AKTIENGESELLSCHAFT, 80333 München (DE)
(72) Erfinder: Berndt, Thomas, 12524 Berlin (DE); Reymann, Helge, 14167 Berlin (DE)

(57) **Zusammenfassung**

Es wird ein Verfahren zum Vorheizen eines zu beschichtenden Bauteils (1), insbesondere eines mittels physikalischer Abscheidung aus der Gasphase zu beschichtenden Bauteils (1), zur Verfügung gestellt, in dem verschiedenen Bereichen des Bauteils (1) definierte, voneinander verschiedene Heizleistungen zugeführt werden.

## Beschreibung

Die Erfindung betrifft ein Verfahren zum Vorheizen eines Bauteils sowie ein Verfahren zum Beschichten eines Bauteils mittels Abscheidung aus der Gasphase und insbesondere ein Verfahren zum Beschichten eines Turbinenbauteils mit einer keramischen Beschichtung.

Turbinenbauteile, beispielsweise Turbinenschaufeln, werden mit wärmedämmenden Keramikbeschichtungen versehen, um ihre Widerstandsfähigkeit gegen die in einer Gasturbinenanlage auftretenden Temperaturen zu erhöhen. Als derartige Wärmedämmbeschichtungen (TBC, Thermal Barrier Coating) können beispielsweise Zirkonoxid-Beschichtungen (ZrO₂- Beschichtungen) aufgebracht werden, die mit Yttriumoxid (Y₂O₃) wenigstens teilstabilisiert sind.

Das Aufbringen einer auf Zirkonoxid basierenden Wärmedämmbeschichtung auf eine Turbinenschaufel ist beispielsweise in US 4,676,994 beschrieben. Dort wird die Beschichtung mittels physikalischer Abscheidung aus der Gasphase (PVD, Physical Vapor Deposition) aufgebracht. Eine Schmelze des Keramikmaterials wird in einem Tiegel in einer Vakuumkammer so weit erhitzt, dass ein rascher Verdampfungsprozess eintritt. Verdampfte Keramikmoleküle lagern sich dabei auf der Oberfläche des zu beschichtenden Bauteils ab.

Vor dem Beschichten des Bauteils findet ein Vorwärmprozess statt, der einerseits dazu dient, eine Aluminiumoxid (Al₂O₃) bildende Schicht wenigstens teilweise in Aluminiumoxid umzuwandeln und andererseits dazu, Gase aus der Bauteiloberfläche herauszutreiben und die Bauteiloberfläche zu säubern. Im in US 4,676,994 beschriebenen Vorheizprozess wird die Turbinenschaufel in einer Vakuumkammer, in welcher ein Druck von weniger als 10⁻³ Torr herrscht, mittels Strahlungs- oder Elektronenstrahlheizen auf eine Temperatur zwischen 870°C und 1100°C vorgeheizt.

Aufgabe der vorliegenden Erfindung ist es, ein gegenüber diesem Stand der Technik verbessertes Verfahren zum Vorheizen eines Bauteils, insbesondere eines mittels physikalischer Abscheidung aus der Gasphase zu beschichtenden Bauteils, zur Verfügung zu stellen.

Es ist eine weitere Aufgabe der Erfindung, ein gegenüber dem genannten Stand der Technik verbessertes Verfahren zum Beschichten eines Bauteils zur Verfügung zu stellen.

Die erste Aufgabe wird durch ein Verfahren nach Anspruch 1 gelöst, die zweite Aufgabe durch ein Verfahren zum Beschichten eines Bauteils nach Anspruch 10.

Die abhängigen Ansprüche enthalten vorteilhafte Ausgestaltungen der Erfindung.

Im erfindungsgemäßen Verfahren zum Vorheizen eines Bauteils werden verschiedenen Bereichen des Bauteils voneinander verschiedene Heizleistungen zugeführt. Dies ermöglicht es beispielsweise, verschiedene Bereiche des Bauteils unterschiedlich schnell aufzuheizen oder gezielt Temperaturgradienten entlang der Bauteiloberfläche zu erzeugen. So kann bspw. über die Temperatur eines Bereiches des Bauteils die über die Bildungsrate von Aluminiumoxid aus einer Aluminiumoxid bildenden Beschichtung gezielt lokal beeinflusst werden. Zudem kann das Vorheizen des Bauteils gleichmäßiger erfolgen, beispielsweise indem Bereiche mit einer hohen Materialstärke intensiver geheizt werden als solche mit einer geringen Materialstärke. Auf diese Weise lässt sich erreichen, dass diese Bereiche gleich schnell auf eine gewünschte Zieltemperatur gebracht werden können. Spannungen aufgrund temporär auftretender Temperaturunterschiede lassen sich so vermeiden. Zudem besteht grundsätzlich die Möglichkeit, Bereiche, welche eine große Menge an Gasen in der Oberfläche enthalten, bei einer höheren Temperatur ausgasen zu lassen, als solche Bereiche, bei denen ein geringerer Anteil an Gasen in der Oberfläche gespeichert ist. Auf diese Weise kann erreicht werden, dass beide Bereiche in etwa gleich schnell ausgasen.

In einer Ausgestaltung des Verfahrens rotiert das Bauteil während des Vorheizens um eine Rotationsachse. In einer Weiterbildung dieser Ausgestaltung ist dem Umfang des Bauteils bezüglich der Rotationsachse eine Anzahl von Winkelsektoren zugeordnet, die jeweils einen Winkelbereich und eine bestimmte Heizintensität oder eine zu erzielende Temperatur repräsentieren.

Das Heizen des Bauteils kann im erfindungsgemäßen Verfahren insbesondere mittels Strahlungsheizung, bspw. mittels Elektronenstrahlheizung, also einer Strahlungsheizung mit einem Elektronenstrahl als Heizstrahl, erfolgen. Während des Heizens rotiert das Bauteil vorteilhafterweise um die Rotationsachse. In diesem Fall kann der Heizstrahl das Bauteil bei jeder Umdrehung in jedem Winkelsektor wenigstens einmal scannen, so dass nach einer vollständigen Umdrehung die gesamte Oberfläche des Bauteils vom Heizstrahl gescannt worden ist. Die Rotation während des Scannens mit dem Heizstrahl kann dabei insbesondere mit einer dem jeweiligen Sektor zugeordneten Umdrehungsgeschwindigkeit erfolgen.

Elektronenstrahlheizung bietet sich insbesondere als Strahlungsheizung an, da sie die Möglichkeit bietet, den Elektronenstrahl mittels magnetischer Linsen zu fokussieren und so gezielt lokale Bereiche des Bauteils zu heizen. Daneben bietet sie die Möglichkeit, den Elektronenstrahl mittels elektrischer und/oder magnetischer Felder abzulenken, so dass sich der mit dem Elektronenstrahl bestrahlte Bereich des Bauteils in einfacher Weise einstellen lässt. In einer Ausgestaltung des Verfahrens kann daher die Strahlrichtung des Elektronenstrahls wenigstens entlang der Rotationsachse des Bauteils verschwenkt werden. Die Verschwenkbarkeit der Strahlrichtung in Richtung der Rotationsachse und die Rotation des Bauteils ermöglichen dann im Zusammenspiel ein gezieltes lokales Aufheizen aller Oberflächenabschnitte des vorzuheizenden Bauteils während einer Rotationsperiode. Das erfindungsgemäße Verfahren eignet sich insbesondere auch zum Umwandeln einer Aluminiumoxid bildenden Schicht wenigstens teilweise in Aluminiumoxid.

Das erfindungsgemäße Verfahren kann insbesondere zum Vorheizen eines zu beschichtenden Turbinenbauteils, insbesondere einer Turbinenschaufel, vor dem Aufbringen der Beschichtung eingesetzt werden.

Erfindungsgemäß wird außerdem ein Verfahren zum Beschichten eines Bauteils zur Verfügung gestellt, indem vor dem eigentlichen Beschichtungsprozess ein Vorheizen stattfindet. Das Vorheizen erfolgt nach dem erfindungsgemäßen Verfahren zum Vorheizen eines Bauteils. Das Verfahren zum Beschichten eines Bauteils kann hierbei ein Beschichten mittels physikalischer Abscheidung aus der Dampfphase (PVD, Physical Vapor Deposition), beispielsweise mittels Elektronenstrahl (EBPVD, Electron Beam Physical Vapor Deposition), umfassen. Die auf das Bauteil abzuscheidende Beschichtung kann insbesondere eine keramische Beschichtung, etwa eine keramische Wärmedämmschicht, sein.

Weitere Merkmale, Eigenschaften und Vorteile der Erfindung ergeben sich aus der nachfolgenden Beschreibung eines Ausführungsbeispiels unter Bezugaufnahme auf die beiliegenden Figuren.
- Figur 1: zeigt beispielhaft eine Gasturbine in einem Längsteilschnitt.
- Figur 2: zeigt in perspektivischer Ansicht eine Laufschaufel oder Leitschaufel einer Strömungsmaschine.
- Figur 3: zeigt eine Brennkammer einer Gasturbine.
- Figur 4: zeigt eine mittels eines Elektronenstrahls lokal geheizte Turbinenschaufel in einer schematischen Darstellung.
- Figur 5: zeigt eine mögliche Ausgestaltung des Pfades des Elektronenstrahls über die Oberfläche der Turbinenschaufel.
- Figur 6: zeigt eine mögliche Unterteilung des vorzuheizenden Bauteils in Sektoren bezüglich des Umfangs um eine Rotationsachse.
- Figur 7: zeigt unterschiedliche geheizte Zonen der Turbinenschaufel aus Figur 1.

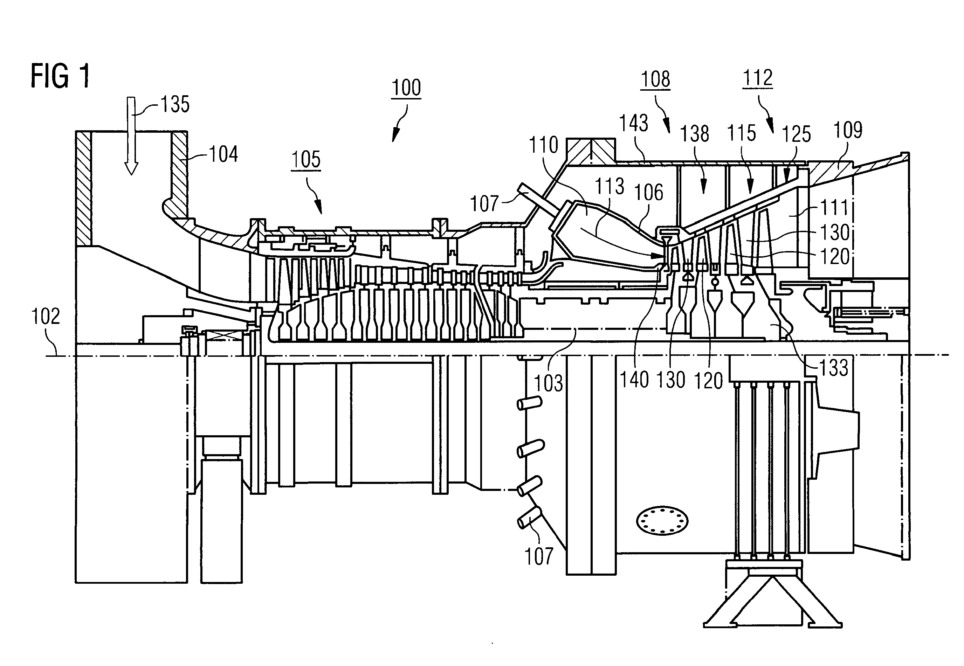

Die Figur 1 zeigt beispielhaft eine Gasturbine 100 in einem Längsteilschnitt. Die Gasturbine 100 weist im Inneren einen um eine Rotationsachse 102 drehgelagerten Rotor 103 auf, der auch als Turbinenläufer bezeichnet wird. Entlang des Rotors 103 folgen aufeinander ein Ansauggehäuse 104, ein Verdichter 105, eine beispielsweise torusartige Brennkammer 110, insbesondere Ringbrennkammer 106, mit mehreren koaxial angeordneten Brennern 107, eine Turbine 108 und das Abgasgehäuse 109.

Die Ringbrennkammer 106 kommuniziert mit einem beispielsweise ringförmigen Heißgaskanal 111. Dort bilden beispielsweise vier hintereinandergeschaltete Turbinenstufen 112 die Turbine 108.

Jede Turbinenstufe 112 ist beispielsweise aus zwei Schaufelringen gebildet. In Strömungsrichtung eines Arbeitsmediums 113 gesehen folgt im Heißgaskanal 111 einer Leitschaufelreihe 115 eine aus Laufschaufeln 120 gebildete Reihe 125.

Die Leitschaufeln 130 sind dabei an einem Innengehäuse 138 eines Stators 143 befestigt, wohingegen die Laufschaufeln 120 einer Reihe 125 beispielsweise mittels einer Turbinenscheibe 133 am Rotor 103 angebracht sind.

An dem Rotor 103 angekoppelt ist ein Generator oder eine Arbeitsmaschine (nicht dargestellt).

Während des Betriebes der Gasturbine 100 wird vom Verdichter 105 durch das Ansauggehäuse 104 Luft 135 angesaugt und verdichtet. Die am turbinenseitigen Ende des Verdichters 105 bereitgestellte verdichtete Luft wird zu den Brennern 107 geführt und dort mit einem Brennmittel vermischt. Das Gemisch wird dann unter Bildung des Arbeitsmediums 113 in der Brennkammer 110 verbrannt. Von dort aus strömt das Arbeitsmedium 113 entlang des Heißgaskanals 111 vorbei an den Leitschaufeln 130 und den Laufschaufeln 120. An den Laufschaufeln 120 entspannt sich das Arbeitsmedium 113 impulsübertragend, so dass die Laufschaufeln 120 den Rotor 103 antreiben und dieser die an ihn angekoppelte Arbeitsmaschine.

Die dem heißen Arbeitsmedium 113 ausgesetzten Bauteile unterliegen während des Betriebes der Gasturbine 100 thermischen Belastungen. Die Leitschaufeln 130 und Laufschaufeln 120 der in Strömungsrichtung des Arbeitsmediums 113 gesehen ersten Turbinenstufe 112 werden neben den die Ringbrennkammer 106 auskleidenden Hitzeschildsteinen am meisten thermisch belastet.

Um den dort herrschenden Temperaturen standzuhalten, können diese mittels eines Kühlmittels gekühlt werden.

Ebenso können Substrate der Bauteile eine gerichtete Struktur aufweisen, d.h. sie sind einkristallin (SX-Struktur) oder weisen nur längsgerichtete Körner auf (DS-Struktur).

Als Material für die Bauteile, insbesondere für die Turbinenschaufel 120, 130 und Bauteile der Brennkammer 110 werden beispielsweise eisen-, nickel- oder kobaltbasierte Superlegierungen verwendet. Solche Superlegierungen sind beispielsweise aus der EP 1 204 776 B1, EP 1 306 454, EP 1 319 729 A1, WO 99/67435 oder WO 00/44949 bekannt; diese Schriften sind Teil der Offenbarung.

Ebenso können die Schaufeln 120, 130 Beschichtungen gegen Korrosion (MCrAlY; M ist zumindest ein Element der Gruppe Eisen (Fe), Kobalt (Co), Nickel (Ni), Y ist ein Aktivelement und steht für Yttrium (Y) und/oder Silizium und/oder zumindest ein Element der Seltenen Erden bzw. Hafnium). Solche Legierungen sind bekannt aus der EP 0 486 489 B1, EP 0 786 017 B1, EP 0 412 397 B1 oder EP 1 306 454 A1, die Teil dieser Offenbarung sein sollen.

Auf der MCrAlY kann noch eine Wärmedämmschicht vorhanden sein, und besteht beispielsweise aus ZrO₂, Y₂O₃-ZrO₂, d.h. sie ist nicht, teilweise oder vollständig stabilisiert durch Yttriumoxid und/oder Kalziumoxid und/oder Magnesiumoxid.
Durch geeignete Beschichtungsverfahren wie z.B. Elektronenstrahlverdampfen (EB-PVD) werden stängelförmige Körner in der Wärmedämmschicht erzeugt.

Die Leitschaufel 130 weist einen dem Innengehäuse 138 der Turbine 108 zugewandten Leitschaufelfuß (hier nicht dargestellt) und einen dem Leitschaufelfuß gegenüberliegenden Leitschaufelkopf auf. Der Leitschaufelkopf ist dem Rotor 103 zugewandt und an einem Befestigungsring 140 des Stators 143 festgelegt.

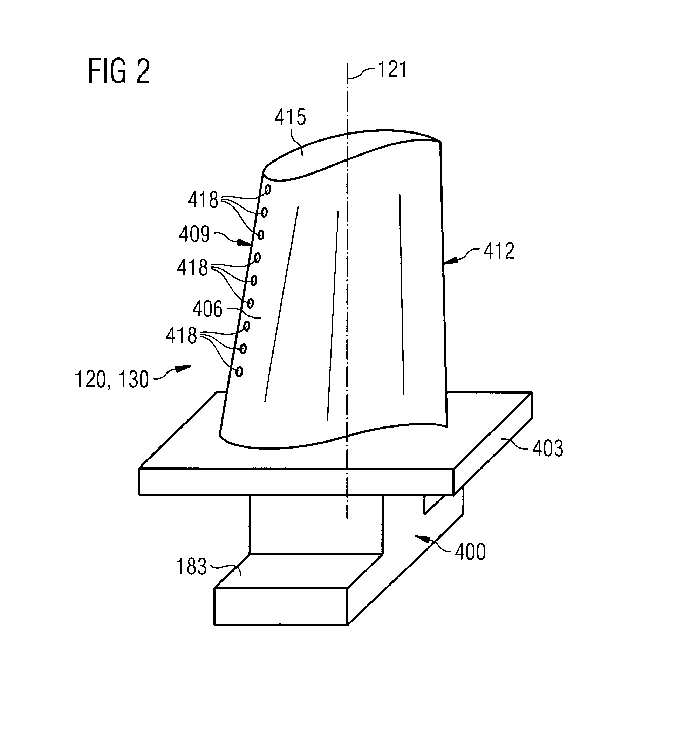

Figur 2 zeigt in perspektivischer Ansicht eine Laufschaufel 120 oder Leitschaufel 130 einer Strömungsmaschine, die sich entlang einer Längsachse 121 erstreckt.

Die Strömungsmaschine kann eine Gasturbine eines Flugzeugs oder eines Kraftwerks zur Elektrizitätserzeugung, eine Dampfturbine oder ein Kompressor sein.

Die Schaufel 120, 130 weist entlang der Längsachse 121 aufeinander folgend einen Befestigungsbereich 400, eine daran angrenzende Schaufelplattform 403 sowie ein Schaufelblatt 406 auf. Als Leitschaufel 130 kann die Schaufel 130 an ihrer Schaufelspitze 415 eine weitere Plattform aufweisen (nicht dargestellt).

Im Befestigungsbereich 400 ist ein Schaufelfuß 183 gebildet, der zur Befestigung der Laufschaufeln 120, 130 an einer Welle oder einer Scheibe dient (nicht dargestellt).
Der Schaufelfuß 183 ist beispielsweise als Hammerkopf ausgestaltet. Andere Ausgestaltungen als Tannenbaum- oder Schwalbenschwanzfuß sind möglich.

Die Schaufel 120, 130 weist für ein Medium, das an dem Schaufelblatt 406 vorbeiströmt, eine Anströmkante 409 und eine Abströmkante 412 auf.

Bei herkömmlichen Schaufeln 120, 130 werden in allen Bereichen 400, 403, 406 der Schaufel 120, 130 beispielsweise massive metallische Werkstoffe, insbesondere Superlegierungen verwendet. Solche Superlegierungen sind beispielsweise aus der EP 1 204 776 B1, EP 1 306 454, EP 1 319 729 A1, WO 99/67435 oder WO 00/44949 bekannt; diese Schriften sind Teil der Offenbarung. Die Schaufel 120, 130 kann hierbei durch ein Gussverfahren, auch mittels gerichteter Erstarrung, durch ein Schmiedeverfahren, durch ein Fräsverfahren oder Kombinationen daraus gefertigt sein.

Werkstücke mit einkristalliner Struktur oder Strukturen werden als Bauteile für Maschinen eingesetzt, die im Betrieb hohen mechanischen, thermischen und/oder chemischen Belastungen ausgesetzt sind. Die Fertigung von derartigen einkristallinen Werkstücken erfolgt z.B. durch gerichtetes Erstarren aus der Schmelze. Es handelt sich dabei um Gießverfahren, bei denen die flüssige metallische Legierung zur einkristallinen Struktur, d.h. zum einkristallinen Werkstück, oder gerichtet erstarrt. Dabei werden dendritische Kristalle entlang dem Wärmefluss ausgerichtet und bilden entweder eine stängelkristalline Kornstruktur (kolumnar, d.h. Körner, die über die ganze Länge des Werkstückes verlaufen und hier, dem allgemeinen Sprachgebrauch nach, als gerichtet erstarrt bezeichnet werden) oder eine einkristalline Struktur, d.h. das ganze Werkstück besteht aus einem einzigen Kristall. In diesen Verfahren muss man den Übergang zur globulitischen (polykristallinen) Erstarrung meiden, da sich durch ungerichtetes Wachstum notwendigerweise transversale und longitudinale Korngrenzen ausbilden, welche die guten Eigenschaften des gerichtet erstarrten oder einkristallinen Bauteiles zunichte machen. Ist allgemein von gerichtet erstarrten Gefügen die Rede, so sind damit sowohl Einkristalle gemeint, die keine Korngrenzen oder höchstens Kleinwinkelkorngrenzen aufweisen, als auch Stängelkristallstrukturen, die wohl in longitudinaler Richtung verlaufende Korngrenzen, aber keine transversalen Korngrenzen aufweisen. Bei diesen zweitgenannten kristallinen Strukturen spricht man auch von gerichtet erstarrten Gefügen (directionally solidified structures). Solche Verfahren sind aus der US-PS 6,024,792 und der EP 0 892 090 A1 bekannt; diese Schriften sind Teil der Offenbarung.

Ebenso können die Schaufeln 120, 130 Beschichtungen gegen Korrosion oder Oxidation (MCrA1Y; M ist zumindest ein Element der Gruppe Eisen (Fe), Kobalt (Co), Nickel (Ni), y ist ein Aktivelement und steht für Yttrium (Y) und/oder Silizium und/oder zumindest ein Element der Seltenen Erden, bzw. Hafnium (Hf)). Solche Legierungen sind bekannt aus der EP 0 486 489 B1, EP 0 786 017 B1, EP 0 412 397 B1 oder EP 1 306 454 A1, die Teil dieser Offenbarung sein sollen.

Auf der MCrAlY kann noch eine Wärmedämmschicht vorhanden sein und besteht beispielsweise aus ZrO₂, Y₂O₃-ZrO₂, d.h. sie ist nicht, teilweise oder vollständig stabilisiert durch Yttriumoxid und/oder Kalziumoxid und/oder Magnesiumoxid. Durch geeignete Beschichtungsverfahren wie z.B. Elektronenstrahlverdampfen (EB-PVD) werden stängelförmige Körner in der Wärmedämmschicht erzeugt.

Wiederaufarbeitung (Refurbishment) bedeutet, dass Bauteile 120, 130 nach ihrem Einsatz gegebenenfalls von Schutzschichten befreit werden müssen (z.B. durch Sandstrahlen). Danach erfolgt eine Entfernung der Korrosions- und/oder Oxidationsschichten bzw. -produkte. Gegebenenfalls werden auch noch Risse im Bauteil 120, 130 repariert. Danach erfolgt eine Wiederbeschichtung des Bauteils 120, 130 und ein erneuter Einsatz des Bauteils 120, 130.

Die Schaufel 120, 130 kann hohl oder massiv ausgeführt sein. Wenn die Schaufel 120, 130 gekühlt werden soll, ist sie hohl und weist ggf. noch Filmkühllöcher 418 (gestrichelt angedeutet) auf.

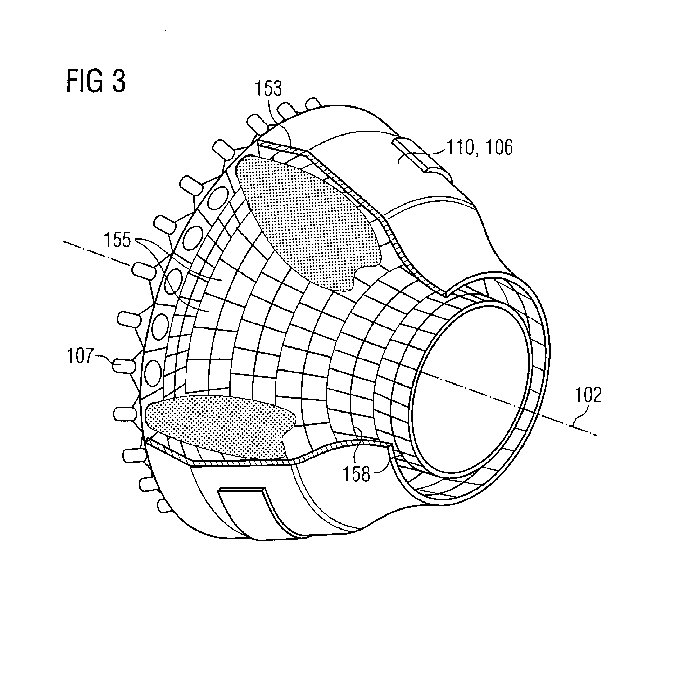

Die Figur 3 zeigt eine Brennkammer 110 einer Gasturbine. Die Brennkammer 110 ist beispielsweise als so genannte Ringbrennkammer ausgestaltet, bei der eine Vielzahl von in Umfangsrichtung um die Rotationsachse 102 herum angeordneten Brennern 107 in einen gemeinsamen Brennkammerraum münden. Dazu ist die Brennkammer 110 in ihrer Gesamtheit als ringförmige Struktur ausgestaltet, die um die Rotationsachse 102 herum positioniert ist.

Zur Erzielung eines vergleichsweise hohen Wirkungsgrades ist die Brennkammer 110 für eine vergleichsweise hohe Temperatur des Arbeitsmediums M von etwa 1000°C bis 1600°C ausgelegt. Um auch bei diesen, für die Materialien ungünstigen Betriebsparametern eine vergleichsweise lange Betriebsdauer zu ermöglichen, ist die Brennkammerwand 153 auf ihrer dem Arbeitsmedium M zugewandten Seite mit einer aus Hitzeschildelementen 155 gebildeten Innenauskleidung versehen.

Jedes Hitzeschildelement 155 ist arbeitsmediumsseitig mit einer besonders hitzebeständigen Schutzschicht ausgestattet oder aus hochtemperaturbeständigem Material gefertigt. Dies können massive keramische Steine oder Legierungen mit MCrAlY und/oder keramischen Beschichtungen sein. Die Materialien der Brennkammerwand und deren Beschichtungen können ähnlich der Turbinenschaufeln sein.

Aufgrund der hohen Temperaturen im Inneren der Brennkammer 110 kann zudem für die Hitzeschildelemente 155 bzw. für deren Halteelemente ein Kühlsystem vorgesehen sein.

Die Brennkammer 110 ist insbesondere für eine Detektion von Verlusten der Hitzeschildelemente 155 ausgelegt. Dazu sind zwischen der Brennkammerwand 153 und den Hitzeschildelementen 155 eine Anzahl von Temperatursensoren 158 positioniert.

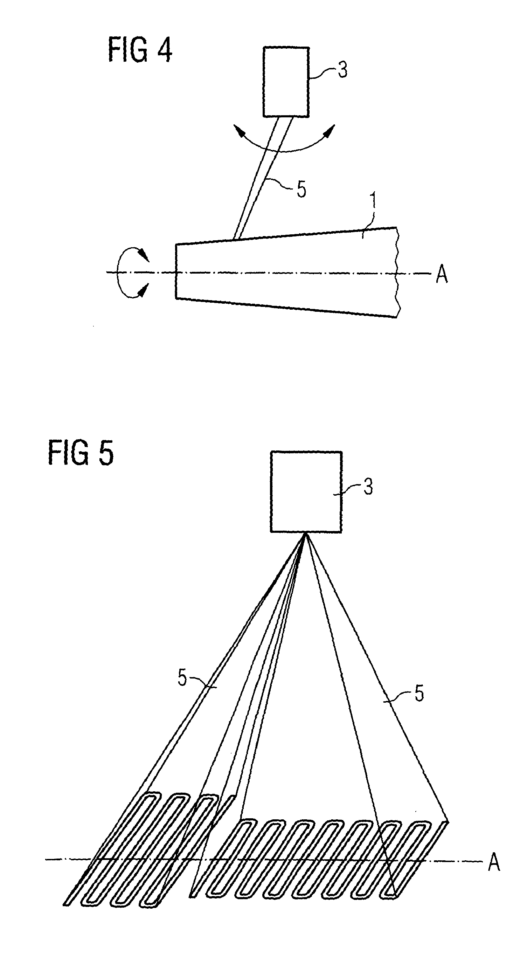

Das erfindungsgemäße Verfahren wird nachfolgend unter Bezugnahme auf Figur 4 anhand eines Beschichtungsprozesses für eine Turbinenschaufel 1 als einem zu beschichtenden Bauteil beschrieben. Auf die Turbinenschaufel 1 wird ein Beschichtungssystem mittels physikalischer Abscheidung aus der Gasphase aufgebracht, welches eine keramische Wärmedämmschicht und eine darunter befindliche MCrAlY-Schicht umfasst. Als keramische Wärmedämmschicht kommt eine mit Yttrium stabilisierte Zirkonoxid-Schicht zum Einsatz.

Vor dem Aufbringen der keramischen Wärmedämmschicht erfolgt eine Vorbehandlung der Turbinenschaufel 1, in der diese ausgegast, die Schaufeloberfläche gereinigt und eine Aluminiumoxid-Schicht an der Bauteiloberfläche hergestellt wird. Das Erzeugen der Aluminiumoxid-Schicht erfolgt, indem die zuvor mit einer MCrAlY-Schicht versehene Turbinenschaufel 1 vorgeheizt wird. Bei diesem Vorheizen treten gleichzeitig in der Schaufelwand enthaltene Gase aus und es werden etwaige Verschmutzungen der Schaufeloberfläche beseitigt.

Zum Vorbehandeln der Turbinenschaufel 1 wird diese in eine Vakuumkammer eingebracht, die auf einen Druck von etwa 10⁻³ Torr evakuiert wird. Mittels Elektronenstrahlheizung wird die Turbinenschaufel 1 auf Temperaturen zwischen 870°C und 1100°C vorgeheizt und für 10 bis 30 Minuten gehalten. Zum Vorheizen wird die Turbinenschaufel in der Vakuumkammer um ihre Längsachse gedreht und ihre Oberfläche mit einem Elektronenstrahl 5 bestrichen, welcher die zum Heizen nötige Heizleistung zuführt. Die Turbinenschaufel 1 und der Elektronenstrahl 5 sind in Figur 4 stark schematisiert dargestellt. Die Figur zeigt außerdem eine Elektronenstrahloptik 3 zum Fokussieren und Verschwenken des Elektronenstrahls 5 in Richtung der Rotationsachse A, um die die Turbinenschaufel 1 während des Vorheizens gedreht wird.

Die Elektronenstrahloptik 3 umfasst magnetische Linsen und elektrische und/oder magnetische und/oder elektromagnetische Ablenkeinrichtungen, mit denen die Richtung des Elektronenstrahls 5 innerhalb einer durch die Rotationsachse A verlaufenden Ebene verschwenkt werden kann. Auf diese Weise kann der Elektronenstrahl 5 gezielt auf alle Stellen eines axial verlaufenden Streifens der Turbinenschaufel 1 gerichtet werden. Da die Turbinenschaufel 1 außerdem um die Achse A rotiert, kann innerhalb einer Rotationsperiode jeder Punkt der Oberfläche der Turbinenschaufel 1 vom Elektronenstrahl 5 getroffen werden.

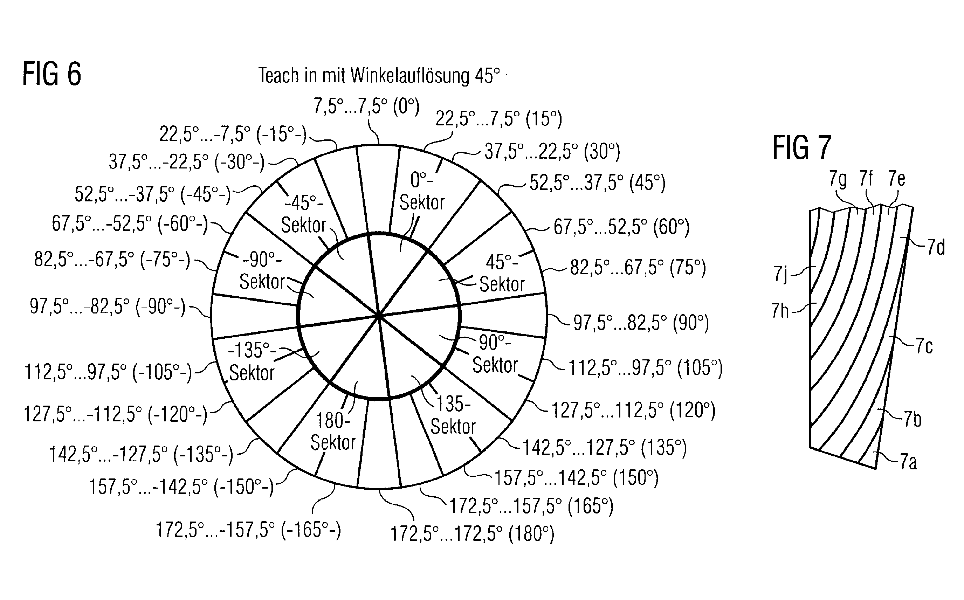

Wenn der Elektronenstrahl auch senkrecht zur Rotationsachse A verschwenkbar realisiert ist, kann der axiale Streifen auch mäanderförmig bestrichen werden. Dabei ist es insbesondere möglich, die einem Streifen oder einem Abschnitt des Streifens zugeführte Heizleistung durch Verändern der Parameter des mäanderförmigen Pfades zu variieren, wie dies schematisch in Figur 5 dargstellt ist.

Auch mittels der Energie, mit der die Elektronen auf die Oberfläche der Turbinenschaufel 1 auftreffen, lässt sich die Heizleistung variieren. Die Energie der auftreffenden Elektronen, lässt sich durch den Wert einer zwischen der Turbinenschaufel 1 und der Elektronenstrahlquelle angelegten Spannung beeinflussen. Durch Variation der anliegenden Spannung in Abhängigkeit vom Oberflächenbereich der Turbinenschaufel 1, auf den der Elektronenstrahl 5 gerade trifft, können verschiedenen Bereiche der Turbinenschaufel 1 unterschiedliche Heizleistungen zugeführt werden.

Während des Vorheizens rotiert die Turbinenschaufel 1 wie bereits erwähnt um die Rotationsachse A. Eine Rotationsperiode wird dabei in einer Anzahl von Winkelsektoren unterteilt, die dem Umfang der Turbinenschaufel 1 bzgl. der Rotationsachse A zugeordnet sind. Im vorliegenden Ausführungsbeispiel sind 24 Sektoren zu je 15° vorhanden(vgl. Figur 6). Der Elektronenstrahl 5 wird nun beim Vorheizen so gesteuert, dass er in jeder durch einen Sektor repräsentierten Phase der Rotation einen axialen Streifen der Turbinenschaufel 1 bspw. linear oder mäanderförmig überstreicht und dabei diesen Streifen heizt. Wenn dabei die zwischen der Turbinenschaufel 1 und der Elektronenquelle anliegende Spannung geeignet variiert wird oder die Parameter des mäanderförmigen Pfades geeignet verändert werden, können unterschiedlichen Abschnitten dieses Streifens unterschiedliche Heizleistungen zugeführt werden. Wenn der Streifen vom Elektronenstrahl 5 bestrichen worden ist, wird die Turbinenschaufel 1 um 15° weitergedreht und der nächste Streifen bestrichen. Das Drehen der Turbinenschaufel 1 erfolgt hierbei schrittweise, so dass die Turbinenschaufel 1 still steht, während der Elektronenstrahl 5 den axialen Streifen bestrahlt. Alternativ ist es jedoch auch möglich, die Turbinenschaufel 1 während des Bestrahlens des Streifens mit einer dem jeweiligen Sektor zugeordneten Umdrehungsgeschwindigkeit zu drehen. In diesem Fall überstreicht der Elektronenstrahl 5 keine geraden Streifen auf der Oberfläche der Turbinenschaufel 1, sondern helixförmige um einen Umfangsabschnitt der Turbinenschaufel 1 gewundene Streifen 7, wie in Figur 7 zur Verdeutlichung stark übertrieben dargestellt ist.

Die Winkelgeschwindigkeit, mit der die Turbinenschaufel 1 während des Vorheizens rotiert, sollte hoch genug sein, damit eine bestrahlte Stelle nicht wesentlich abkühlt, bevor sie nach einer vollen Umdrehung der Turbinenschaufel 1 um die Rotationsachse A erneut bestrahlt wird.

Das Vorheizen der Turbinenschaufel 1 wird im vorliegenden Ausführungsbeispiel so lange durchgeführt, bis sich aus der MCrAlY-Schicht eine Aluminiumoxid-Schicht mit der gewünschten Dicke herausgebildet hat. Es sei an dieser Stelle darauf hingewiesen, dass statt der MCrAlY-Schicht auch eine einfache Aluminiumschicht als Aluminiumoxid bildende Schicht Verwendung finden kann.

Nachdem das Vorheizen abgeschlossen ist, wird die Turbinenschaufel in eine andere Vakuumkammer gebracht, in der sie mit der keramischen Wärmedämmschicht beschichtet wird. Das Beschichten erfolgt beispielsweise mittels physikalischer Abscheidung aus der Gasphase, indem ein Keramikmaterial geschmolzen und verdampft wird, welches sich auf der Oberfläche der Turbinenschaufel ablagert. Insbesondere kann auf die während des Vorheizens gebildete Aluminiumoxid-Schicht eine Zirkonoxidschicht abgeschieden werden, deren Struktur mit Yttriumoxid (Y₂O₃) teilweise oder vollständig stabilisiert ist.

## Patentansprüche

1. Verfahren zum Vorheizen eines zu beschichtenden Bauteils (1),
insbesondere eines mittels physikalischer Abscheidung aus der Gasphase zu beschichtenden Bauteils (1),
**dadurch gekennzeichnet, dass**
verschiedenen Bereichen des Bauteils (1) definierte, voneinander verschiedene Heizleistungen zugeführt werden.

2. Verfahren nach Anspruch 1,
**dadurch gekennzeichnet, dass**
das Bauteil (1) während des Heizens um eine Rotationsachse (A) rotiert.

3. Verfahren nach Anspruch 2,
**dadurch gekennzeichnet, dass**
dem Umfang des Bauteils (1) bezüglich der Rotationsachse (A) eine Anzahl Sektoren zugeordnet ist, die jeweils einen Winkelbereich und eine bestimmte Heizintensität oder eine bestimmte Temperatur repräsentieren.

4. Verfahren nach Anspruch 1, 2 oder 3,
**dadurch gekennzeichnet, dass**
das Bauteil (1) mittels Strahlungsheizung geheizt wird.

5. Verfahren nach Anspruch 3 und Anspruch 4,
**dadurch gekennzeichnet, dass**
im Rahmen der Strahlungsheizung das Bauteil (1) bei jeder Umdrehung mit einem Heizstrahl (5) in jedem Sektor wenigstens einmal in Richtung der Rotationsachse A gescannt wird.

6. Verfahren nach Anspruch 5,
**dadurch gekennzeichnet, dass**
das Bauteil (1) während des Scannens mit dem Heizstrahl (5) mit einer dem jeweiligen Sektor zugeordneten Umdrehungsgeschwindigkeit rotiert.

7. Verfahren nach einem der Ansprüche 4 bis 6,
**dadurch gekennzeichnet, dass**
das Heizen mit wenigstens einem auf das Bauteil (1) gerichteten Elektronenstrahl (5) als Heizstrahl erfolgt, wobei die Strahlrichtung des Elektronenstrahls (5) entlang der Rotationsachse verschwenkbar ist.

8. Verfahren nach einem der Ansprüche 1 bis 7,
**dadurch gekennzeichnet, dass**
während des Vorheizens eine Aluminiumoxid bildende Schicht wenigstens teilweise in Aluminiumoxid umgewandelt wird.

9. Verfahren nach einem der Ansprüche 1 bis 8,
**dadurch gekennzeichnet, dass**
das zu beschichtende Bauteil (1) ein Turbinenbauteil, insbesondere eine Turbinenschaufel ist.

10. Verfahren zum Beschichten eines Bauteils (1),
in dem vor dem eigentlichen Beschichtungsprozess ein Vorheizen stattfindet,
**dadurch gekennzeichnet, dass**
das Vorheizen nach einem der vorangehenden Ansprüche erfolgt.

11. Verfahren nach Anspruch 10,
**dadurch gekennzeichnet, dass**
das Beschichten mittels physikalischer Abscheidung aus der Gasphase erfolgt.

12. Verfahren nach Anspruch 10 oder 11,
**dadurch gekennzeichnet, dass**
eine keramische Beschichtung auf das Bauteil (1) aufgebracht wird.
